# EUROPEAN PATENT APPLICATION

(11) **EP 3 806 171 A1**
(43) Date of publication of application: **14.04.2021**
(21) Application number: 19806689.6
(22) Date of filing: 24.04.2019
(51) Int. Cl.: H01L 33/56, H01L 33/54, H01L 33/50, H01L 33/36, H01L 33/62

(54) **LIGHT-EMITTING DEVICE**

(30) Priority: 24.05.2018 KR 20180058878
(71) Applicant: Seoul Semiconductor Co., Ltd., Gyeonggi-do 15429 (KR)
(72) Inventor: LEE, Chung Hoon, Ansan-Si Gyeonggi-do 15429 (KR)
(74) Representative: Stolmár & Partner Patentanwälte PartG mbB
(86) International application number: PCT/KR2019/004973
(87) International publication number: WO 2019/225866

(57) **Abstract**

Disclosed is a light emitting device. The light-emitting device includes a light emitting diode chip, a first light transmitting resin part, a second light transmitting resin part, and a barrier part. The second light transmitting resin part covers an upper portion of the first light transmitting resin part and an upper portion of the light emitting diode chip. The barrier part surrounds side surfaces of the light emitting diode chip, the first light transmitting resin part and the second light transmitting resin part and a lower surface of the light emitting diode chip. Here, each of the first light transmitting resin part and the second light transmitting resin part has a width gradually increasing from a lower portion thereof to the upper portion thereof. Further, the inner wall of the barrier part adjoins the side surface of the light emitting diode chip or a lower end of the side surface thereof. The inner wall of the barrier part is divided into a first inner wall having a convexly curved plane and a second inner wall having an inclined plane in cross-sectional view.

## Description

### [Technical Field]

Embodiments of the present disclosure relate to a light emitting device.

### [Background Art]

Generally, a light emitting device (LED) including a light emitting diode chip is used as a light source in various fields, such as a light source for backlights and the like.

The light emitting device emits light having various wavelengths through recombination of electrons and holes in a junction between a p-type semiconductor and an n-type semiconductor upon application of electric current thereto. Due to various advantages of light emitting device, such as longer lifespan, lower power consumption, and better operation characteristics than filaments used in a typical light emitting apparatus, there is increasing demand for the light emitting devices.

In a typical light emitting device, a light emitting diode chip is disposed in a cavity of a barrier. Further, a side surface of the light emitting diode chip closely contacts an inner wall defining the cavity of the barrier. Here, light emitted through the side surface of the light emitting diode chip can be reabsorbed into the light emitting diode chip through light loss or reflection on the inner wall of the barrier closely contacting the light emitting diode chip.

### [Disclosure]

### [Technical Problem]

Embodiments of the present disclosure provide a light emitting device having improved luminous efficacy.

Embodiments of the present disclosure provide a light emitting device having improved durability through improvement in adhesion between components thereof.

### [Technical Solution]

In accordance with embodiments of the present disclosure, there is provided a light emitting device including: a light emitting diode chip, a first light transmitting resin part, a second light transmitting resin part, and a barrier part. The second light transmitting resin part covers an upper portion of the first light transmitting resin part and an upper portion of the light emitting diode chip. The barrier part surrounds side surfaces of the light emitting diode chip, the first light transmitting resin part and the second light transmitting resin part and a lower surface of the light emitting diode chip. Here, each of the first light transmitting resin part and the second light transmitting resin part has a width gradually increasing from a lower portion thereof to the upper portion thereof. Further, the inner wall of the barrier part adjoins the side surface of the light emitting diode chip or a lower end of the side surface thereof. The inner wall of the barrier part is divided into a first inner wall having a convexly curved plane and a second inner wall having an inclined plane in cross-sectional view.

### [Advantageous Effects]

According to embodiments of the present disclosure, the light emitting device and the method of manufacturing the same ensure improvement in luminous efficacy by preventing loss of light emitted through a side surface of a light emitting diode chip.

According to embodiments of the present disclosure, the light emitting device and the method of manufacturing the same can enhance durability through improvement in adhesion between components therebetween.

### [Description of Drawings]

FIG. 1 is a sectional view of a light emitting device according to a first embodiment of the present disclosure.
FIG. 2 is a sectional view of a method of manufacturing a light emitting device according to a second embodiment of the present disclosure.
FIG. 3 to FIG. 12 are sectional views illustrating a method of manufacturing the light emitting device according to the first and second embodiments of the present disclosure.
FIG. 13 is a sectional view of a light emitting device according to a third embodiment of the present disclosure.
FIG. 14 and FIG. 15 are sectional views illustrating a method of manufacturing the light emitting device according to the third embodiment of the present disclosure.
FIG. 16 is a sectional view of a light emitting device according to a fourth embodiment of the present disclosure.
FIG. 17 to FIG. 20 are sectional views illustrating a method of manufacturing the light emitting device according to the fourth embodiment of the present disclosure.
FIG. 21 is a sectional view of a light emitting device according to a fifth embodiment of the present disclosure.
FIG. 22 to FIG. 24 are sectional views illustrating a method of manufacturing the light emitting device according to the fifth embodiment of the present disclosure.

### [Best Mode]

Hereinafter, embodiments of the present disclosure will be described in detail with reference to the accompanying drawings. The following embodiments are provided by way of example so as to fully convey the spirit of the present disclosure to those skilled in the art to which the present disclosure pertains. Accordingly, the present disclosure is not limited to the embodiments disclosed herein and can also be implemented in different forms. In the drawings, widths, lengths, thicknesses, and the like of elements can be exaggerated for clarity and descriptive purposes. Throughout the specification, like reference numerals denote like elements having the same or similar functions.

A light emitting device according to embodiments of the present disclosure includes a light emitting diode chip, a first light transmitting resin part, a second light transmitting resin part, and a barrier part.

The light emitting diode chip emits light. The first light transmitting resin part is formed to surround at least part of a side surface of the light emitting diode chip. The second light transmitting resin part is formed to cover an upper portion of the first light transmitting resin part and an upper portion of the light emitting diode chip. The barrier part is formed to surround side surfaces of the light emitting diode chip, the first light transmitting resin part and the second light transmitting resin part and a lower surface of the light emitting diode chip. Here, each of the first light transmitting resin part and the second light transmitting resin part has a width gradually increasing from a lower portion thereof to the upper portion thereof. Further, the inner wall of the barrier part adjoins the side surface of the light emitting diode chip or a lower end of the side surface thereof. The inner wall of the barrier part is divided into a first inner wall having a convexly curved plane and a second inner wall having an inclined plane in cross-sectional view.

The first inner wall of the barrier part surrounds the side surface of the first light transmitting resin part and the second inner wall of the barrier part surrounds the side surface of the second light transmitting resin part.

The side surface of the first light transmitting resin part may closely contact the first inner wall of the barrier part and includes a concavely curved plane.

The side surface of the second light transmitting resin part may closely contact the second inner wall of the barrier part and includes an inclined plane.

A lower end of the first inner wall of the barrier part may adjoin the lower end of the side surface of the light emitting diode chip.

A lower end of the first inner wall of the barrier part is placed at a height spaced apart from the lower end of the light emitting diode chip while adjoining the side surface of the light emitting diode chip.

An upper end of the first inner wall of the barrier part is coplanar with an upper surface of the light emitting diode chip.

A lower surface of the second light transmitting resin part adjoins an upper surface of the first light transmitting resin part and the upper surface of the light emitting diode chip.

An upper end of the first inner wall of the barrier part is placed higher than the upper surface of the light emitting diode chip.

The first light transmitting resin part surrounds at least part of the side surface of the light emitting diode chip and the upper surface thereof. Here, an entire lower surface of the second light transmitting resin part may adjoin the upper surface of the first light transmitting resin part.

The first light transmitting resin part and the second light transmitting resin part are transparent resins allowing transmission of light therethrough.

For example, the transparent resins are transparent silicone resins.

At least one of the first light transmitting resin part and the second light transmitting resin part may further include a phosphor.

The light emitting device may further include a wavelength conversion part covering an upper surface of the second light transmitting resin part and an upper surface of the barrier part.

For example, the wavelength conversion part may be phosphor-in-glass (PIG).

The inner wall of the barrier part may reflect light emitted from the light emitting diode chip.

The light emitting diode chip is formed with a bump pad formed on the lower surface thereof and connected to an electrode thereof.

At least part of the bump pad of the light emitting diode chip is embedded in the barrier part.

The light emitting device may further include a bonding member formed on a lower portion of the bump pad.

At least part of the bonding member is exposed from a lower surface of the barrier part.

Hereinafter, embodiments of the present disclosure will be described in detail. Unless stated otherwise, the following description will be given with reference to the accompanying drawings.

For example, description that the first inner wall of the barrier part is composed of a convexly curved plane and the second inner wall is composed of an inclined plane is given with reference to cross-sectional views of the light emitting device shown in the drawings. Accordingly, it should be understood that the following description with regard to components is given with reference to the accompany drawings.

For convenience of description and understanding, the cavity of the barrier part according to the present disclosure is defined as a space inside the barrier part in which the light emitting diode chip, the first light transmitting resin part, and the second light transmitting resin part are disposed.

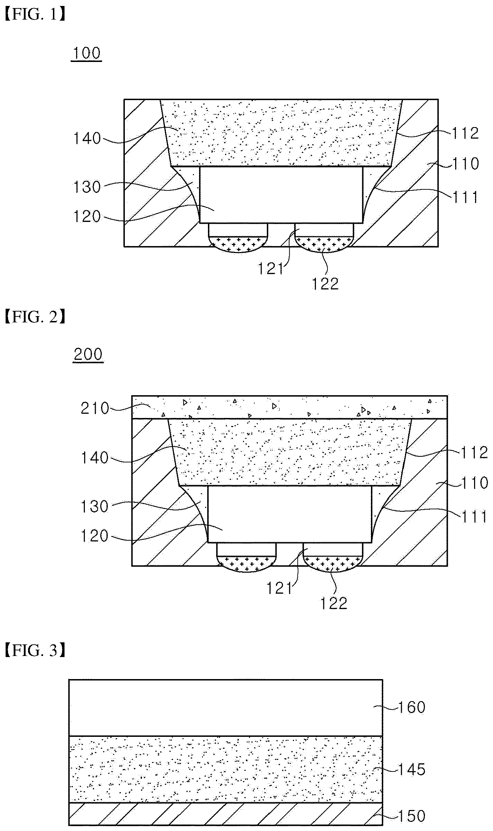

FIG. 1 is a sectional view of a light emitting device according to a first embodiment of the present disclosure.

Referring to FIG. 1, a light emitting device 100 according to the first embodiment includes a barrier part 110, a light emitting diode chip 120, a first light transmitting resin part 130, and a second light transmitting resin part 140.

The barrier part 110 includes a cavity. Referring to FIG. 1, the cavity refers to a space of the barrier part 110 in which the light emitting diode chip 120, the first light transmitting resin part 130 and the second light transmitting resin part 140 are disposed. The cavity is defined inside the barrier part 110 and has a structure that opens a portion of an upper surface of the barrier part 110. The cavity has a width gradually narrowing from an upper portion of the barrier part 110 to a lower portion thereof. As shown in the drawings, the light emitting diode chip 120 is mounted inside the cavity formed in the barrier part 110.

An inner wall of the barrier part 110 defining the cavity is divided into a first inner wall 111 and a second inner wall 112. As shown in the drawings, the first inner wall 111 has a convexly curved plane and the second inner wall 112 has an inclined plane. The first inner wall 111 is disposed between an inner bottom surface of the barrier part 110 defining the cavity and the second inner wall 112. In addition, the second inner wall 112 is disposed between the first inner wall 111 and the upper surface of the barrier part 110.

The barrier part 110 reflects light emitted from the light emitting diode chip 120. For example, the barrier part 110 is formed of a material capable of reflecting light.

The light emitting diode chip 120 includes a semiconductor laminate grown on a growth substrate for growth of semiconductor layers. For example, the semiconductor laminate may be formed of aluminum gallium arsenide, gallium arsenide phosphorus, indium gallium nitride, gallium phosphide, zinc selenide, aluminum indium gallium phosphorus, diamond, zinc oxide, and the like. The light emitting diode chip 120 emits light in different wavelength bands depending upon the material of the semiconductor laminate.

The light emitting diode chip 120 is provided at a lower side thereof with electrodes (not shown) and bump pads 121 electrically connected to the electrodes. The bump pads 121 protrude downwards from a lower surface of the light emitting diode chip 120. The bump pads 121 connect the light emitting diode chip 120 to an external circuit board (not shown). With this structure, the light emitting diode chip 120 is mounted on the external circuit board through flip-chip bonding.

The bump pads 121 of the light emitting diode chip 120 are embedded in the barrier part 110 under the cavity. As a result, the lower surface of the light emitting diode chip 120 adjoins a bottom surface of the cavity.

Further, the bonding member 122 is formed on the bump pad 121 of the light emitting diode chip 120. The bonding member 122 serves to bond the bump pad 121 to the external circuit board and is formed of an electrically conductive material. Accordingly, the bonding member 122 is exposed from a lower surface of the barrier part 110. For example, the bonding member 122 may be a solder.

In this embodiment, the bump pads 121 and the bonding members 122 are formed on the lower surface of the light emitting diode chip 120. However, it should be understood that the light emitting device according to the present disclosure is not limited to the structure wherein the light emitting device includes both the bump pad 121 and the bonding member 122. Alternatively, the light emitting device 100 may include at least one of the bump pad 121 and the bonding member 122. For the light emitting device 100 not including the bonding members 122, the bump pads 121 connected to the electrodes of the light emitting diode chip 120 may be exposed from the lower surface of the barrier part 110. Further, for the light emitting device 100 not including the bump pads 121, the bonding members 122 at least partially exposed from the lower surface of the barrier part 110 may be directly connected to the electrodes of the light emitting diode chip 120.

A lower end of the sidewall of the light emitting diode chip 120 adjoins a lower end of the sidewall of the barrier part 110. That is, the lower end of the first inner wall 111, which is a convexly curved plane of the barrier part 110, adjoins the lower end of the sidewall of the light emitting diode chip 120. Here, the lower end of the light emitting diode chip 120 refers to a portion of the light emitting diode chip 120 at which the lower surface of the light emitting diode chip 120 adjoins a side surface thereof. Further, an upper end of the first inner wall 111 is coplanar with an upper surface of the light emitting diode chip 120.

The first light transmitting resin part 130 is formed to surround the side surface of the light emitting diode chip 120 disposed inside the cavity of the barrier part 110. That is, the first light transmitting resin part 130 is surrounded by the first inner wall 111. Accordingly, the side surface of the first light transmitting resin part 130 is convexly curved corresponding to the curved plane of the first inner wall 111. The first light transmitting resin part 130 is formed of a transparent resin allowing transmission of light therethrough. For example, the first light transmitting resin part 130 may be formed of a transparent silicone resin.

The second light transmitting resin part 140 is formed to cover the upper surfaces of the light emitting diode chip 120 and the first light transmitting resin part 130 inside the cavity of the barrier part 110. That is, the second light transmitting resin part 140 is surrounded by the second inner wall. Accordingly, the side surface of the second light transmitting resin part 140 has a planar structure corresponding to the second inner wall. The second light transmitting resin part 140 is formed of a transparent resin allowing transmission of light therethrough. For example, the second light transmitting resin part 140 is formed of a transparent silicone resin.

The first light transmitting resin part 130 and the second light transmitting resin part 140 may be formed of a transparent resin alone. In one embodiment, at least one of the first light transmitting resin part 130 and the second light transmitting resin part 140 may contain phosphors dispersed in the transparent resin. In this embodiment, light emitted from the light emitting diode chip 120 is subjected to wavelength conversion by the phosphors and then discharged from the light emitting device 100. When both the first light transmitting resin part 130 and the second light transmitting resin part 140 include the phosphors, the phosphor contained in the first light transmitting resin part 130 may be the same as the phosphor contained in the second light transmitting resin part 140. Alternatively, the phosphor of the first light transmitting resin part 130 and the phosphor of the second light transmitting resin part 140 may be formed of different materials to convert light having a certain wavelength into light in different wavelength bands.

The light emitting diode chip 120 emits light not only through the upper surface thereof but also through the side surface thereof. However, in a typical light emitting device, the inner wall of the barrier part closely contacts the entire side surface of the light emitting diode chip. As a result, the typical light emitting device has a problem of light loss by the barrier part when light is emitted from the side surface of the light emitting diode chip.

In the light emitting device 100 according to this embodiment, a space is defined between the light emitting diode chip 120 and the inner wall of the barrier part 110. Accordingly, the light emitting device 100 can prevent light emitted through the side surface of the light emitting diode chip 120 from being lost by the inner wall of the barrier part 110. Further, in the light emitting device 100 according to this embodiment, light emitted through the side surface of the light emitting diode chip 120 is reflected by the inner wall of the barrier part 110 and discharged through the upper surface of the second light transmitting resin part 140. Accordingly, the light emitting device 100 allows light emitted through the side surface of the light emitting diode chip 120 to be discharged outside by preventing loss of the light emitted therethrough, thereby improving luminous efficacy.

Further, the light emitting device 100 according to this embodiment includes the first inner wall 111 having a convexly curved plane. The first inner wall 111 serves to reflect light upwardly of the second light transmitting resin part 140. Thus, the light emitting device 100 according to this embodiment can prevent light emitted from the light emitting diode chip 120 from being reabsorbed into the light emitting diode chip 120.

Further, as shown in FIG. 1, in the light emitting device 100 according to this embodiment, the inner wall of the barrier part 110 is formed to have a sharp inclination. Accordingly, the light emitting device 100 may be applied to products requiring light directionality. For example, the light emitting device 100 may be applied to vehicular head lamps or an edge of a display panel to improve light directionality.

The following description with respect to light emitting devices according to other embodiments and methods of manufacturing the same will focus on different features from the light emitting device according to the above embodiment. For details of omitted components in the following description, refer to the description of the light emitting device according to this embodiment.

FIG. 2 is a sectional view of a method of manufacturing a light emitting device according to a second embodiment of the present disclosure.

Referring to FIG. 2, a light emitting device 200 according to the second embodiment includes a barrier part 110, a light emitting diode chip 120, a first light transmitting resin part 130, a second light transmitting resin part 140, and a wavelength conversion part 210.

The wavelength conversion part 210 is formed to cover upper surfaces of the second light transmitting resin part 140 and the barrier part 110. The wavelength conversion part 210 converts the wavelength of light emitted from the light emitting diode chip 120.

The wavelength conversion part 210 may contain phosphors dispersed in a light transmitting resin and converting the wavelength of light. For example, the light transmitting resin may be a transparent silicone resin. The phosphors may be yellow phosphors, red phosphors, or green phosphors, or may be selected from any phosphors capable of converting the wavelength of light. Alternatively, the wavelength conversion part 210 may be phosphor-in-glass (PIG) in which the phosphor is mixed in glass.

Light emitted from the light emitting diode chip 120 is converted by the wavelength conversion part 210, whereby the light emitting device 200 can emit white light or other colors of light.

Further, the wavelength conversion part 210 covers the upper surfaces of the second light transmitting resin part 140 and the barrier part 110, thereby preventing foreign matter, such as moisture, dust and the like, from entering the light emitting device 200.

According to this embodiment, the first light transmitting resin part 130 and the second light transmitting resin part 140 may include the phosphors or may be free from the phosphors.

FIG. 3 to FIG. 12 are sectional views illustrating a method of manufacturing the light emitting device according to the first and second embodiments of the present disclosure.

FIG. 3 shows a laminate structure in which a support member 150, a light transmitting resin 145 and a photoresist 160 are sequentially stacked in the stated order. The support member 150 supports components of the light emitting device in manufacture thereof. The support member 150 may be a flat sheet or film. For example, the support member 150 may be a flat sheet or film formed of a synthetic resin, glass, or metal.

The light transmitting resin 145 is stacked on the support member 150. The light transmitting resin 145 is formed of a transparent resin allowing transmission of light therethrough. For example, the light transmitting resin 145 is formed of a transparent silicone resin. The light transmitting resin 145 may be formed by spin coating, printing or rolling the transparent resin. The light transmitting resin 145 may be a film formed of a transparent resin. For example, the light transmitting resin 145 may be formed of a transparent silicone resin. Further, the light transmitting resin 145 may contain phosphors dispersed in the transparent resin.

The photoresist 160 is formed on the light transmitting resin 145. The photoresist 160 is formed of a photosensitive resin. The photoresist 160 may be formed on the light transmitting resin 145 by spin coating, printing or rolling, or may be stacked in film form thereon.

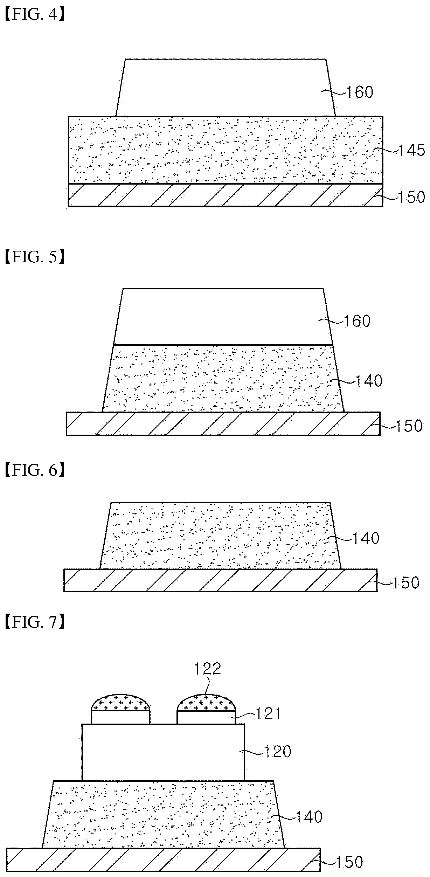

Referring to FIG. 4, the photoresist 160 is subjected to patterning so as to have an inclined side surface. That is, the photoresist 160 is patterned so as to have a width gradually increasing from an upper portion thereof to a lower portion thereof.

For example, the photoresist 160 may be subjected to patterning through exposure and development using a patterned mask (not shown).

Referring to FIG. 5, the light transmitting resin 145 (see FIG. 4) is subjected to patterning.

The light transmitting resin 145 (see FIG. 4) is subjected to patterning through photolithography.

The light transmitting resin 145 (see FIG. 4) is subjected to exposure. Here, a portion of the light transmitting resin 145 (see FIG. 4) covered by the photoresist 160 is protected from the exposure process and a non-covered portion of the light transmitting resin 145 is subjected to exposure. Thereafter, the light transmitting resin 145 (see FIG. 4) is subjected to dry or wet etching to remove the exposed portion thereof. Here, the photoresist 160 may serve to protect the unexposed portion of the light transmitting resin 145 (see FIG. 4) from an etchant for etching.

As such, the light transmitting resin 145 (see FIG. 4) subjected to patterning through photolithography becomes a second light transmitting resin part 140, the width of which is gradually increased from an upper portion thereof to a lower portion thereof, as shown in FIG. 5. The second light transmitting resin part 140 shown in FIG. 5 is the same as the second light transmitting resin part 140 shown in FIG. 1 and FIG. 2.

Referring to FIG. 6, the photoresist 160 (see FIG. 5) is removed. The photoresist 160 (see FIG. 5) may be removed by various methods known in the art.

Referring to FIG. 7, a light emitting diode chip 120 is mounted on the second light transmitting resin part 140. The light emitting diode chip 120 emits light through upper and side surfaces thereof. Further, the light emitting diode chip 120 has bump pads 121 formed on a lower surface thereof. The bump pads 121 may be formed of a material reflecting light. For example, the bump pads 121 may be formed of a metal. Accordingly, the bump pads 121 serve to prevent light from being emitted through a lower surface of the light emitting diode chip 120. Further, a bonding member 122 may be formed on each of the bump pads 121.

The light emitting diode chip 120 is mounted on the second light transmitting resin part 140 such that the upper surface of the light emitting diode chip 120 adjoins the upper surface of the second light transmitting resin part 140.

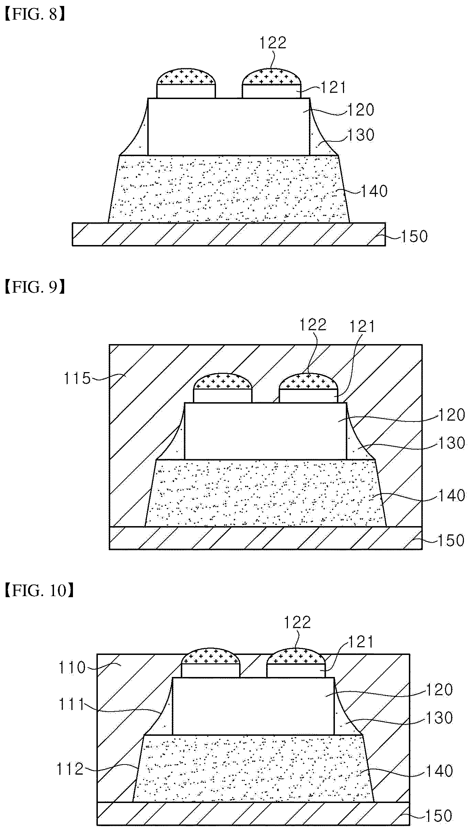

Referring to FIG. 8, a first light transmitting resin part 130 is formed to cover the side surface of the light emitting diode chip 120. A resin member is deposited on the side surface of the light emitting diode chip 120. The resin member is a light transmitting resin allowing transmission of light therethrough. Alternatively, the resin member may contain phosphors dispersed in the light transmitting resin. The resin member has suitable viscosity to flow down on the side surface of the light emitting diode chip 120 while allowing some of the resin member to be kept in a closely contacting state on the side surface of the light emitting diode chip 120. The resin member is deposited in an amount so as to cover the side surface of the light emitting diode chip 120 from a portion of the light emitting diode chip 120, at which the side surface of the light emitting diode chip 120 meets the lower surface thereof, to the upper surface of the second light transmitting resin part 140.

As such, the viscous resin member is deposited on the side surface of the light emitting diode chip 120 to form a first light transmitting resin part 130 that covers the side surface of the light emitting diode chip 120. Further, the first light transmitting resin part 130 is formed to cover the side surface of the light emitting diode chip 120 from the portion of the light emitting diode chip 120, at which the side surface of the light emitting diode chip 120 meets the lower surface thereof, to the upper surface of the second light transmitting resin part 140. That is, the first light transmitting resin part 130 covers the entire side surface of the light emitting diode chip 120. Further, an exposed side surface of the first light transmitting resin part 130 is a concavely curved surface.

Referring to FIG. 9 and FIG. 10, a barrier part 110 is formed.

Referring to FIG. 9, a barrier part resin 115 is formed on the support member 150. The barrier part resin 115 is formed to cover the first light transmitting resin part 130, the second light transmitting resin part 140, and the light emitting diode chip 120.

The barrier part resin 115 may be formed of a material capable of reflecting light. For example, the barrier part resin 115 may be formed of a silicone resin, an epoxy resin, or a thermosetting resin having high heat resistance. Further, the barrier part resin 115 may further include a reflective material, such as TiO₂, SiO₂, Al₂O₃, and the like, in order to improve light reflectivity. The barrier part resin 115 may further contain additional substances, such as antioxidants, release materials, inorganic fillers, curing catalysts, light stabilizers, lubricants, and the like.

Referring to FIG. 10, a portion of the barrier part resin 115 (see FIG. 9) is removed. The barrier part resin 115 (see FIG. 9) is removed to expose the bonding member 122 formed on the light emitting diode chip 120. The barrier part resin 115 (see FIG. 9) may be processed by at least one of a mechanical polishing process and a chemical polishing process known in the art. For example, the barrier part resin 115 (see FIG. 9) may be processed by a grinding process and a fly-cutting process. Through these processes, a barrier part 110 is formed.

The barrier part 110 is formed to surround the side surface of the first light transmitting resin part 130 and the side surface of the second light transmitting resin part 140. An inner wall of the barrier part 110 may be divided into a first inner wall 111 surrounding the side surface of the first light transmitting resin part 130 and a second inner wall 112 surrounding the side surface of the second light transmitting resin part 140. Since the side surface of the first light transmitting resin part 130 is a concave surface, the first inner wall 111 has a convexly curved plane. Further, since the side surface of the second light transmitting resin part 140 is an inclined surface that has a width gradually increasing with increasing distance from the light emitting diode chip 120, the second inner wall 112 also has an inclined plane that has a width gradually increasing with increasing distance from the light emitting diode chip 120.

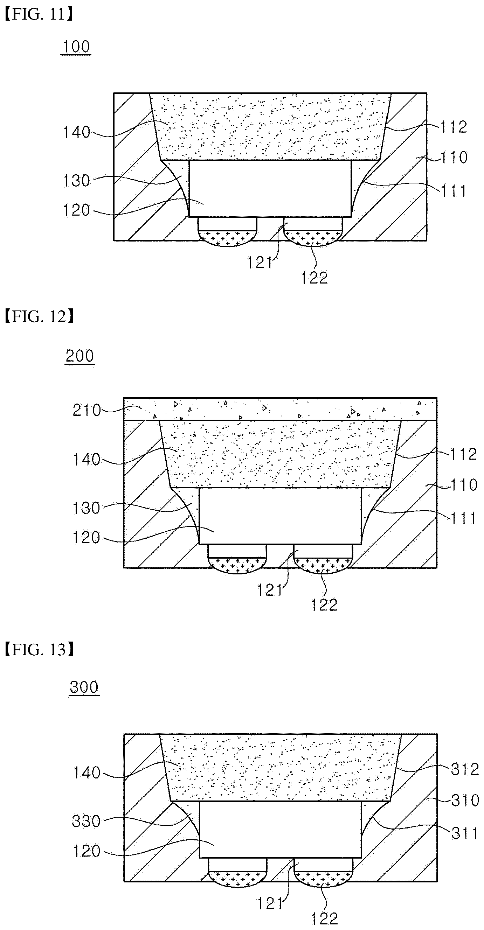

Referring to FIG. 11, the support member 150 (see FIG. 10) is removed. The support member 150 (see FIG. 10) may be removed by applying force to the support member 150 (see FIG. 10) to separate the support member 150 from the barrier part 110 and the second light transmitting resin part 140. Additionally, the support member 150 (see FIG. 10) may be removed by various methods known in the art.

By removing the support member 150 (see FIG. 10), a light emitting device 100 according to the first embodiment is provided.

In the method of forming the light emitting device according to the present disclosure, one light emitting device is illustrated by way of example. However, it should be understood that the present disclosure is not limited thereto. For example, after multiple first light transmitting resin parts 130, multiple second light transmitting resin parts 140 and multiple light emitting diode chips 120 are formed and disposed on a single support member 150 (see FIG. 3), the barrier part 110 may be formed to cover the entirety of the first light transmitting resin parts 130, the second light transmitting resin parts 140 and the light emitting diode chips 120. Then, multiple light emitting devices may be manufactured by dividing adjacent light emitting diode chips 120 from one another through dicing.

Referring to FIG. 12, a wavelength conversion part 210 is formed to cover the second light transmitting resin part 140 and the barrier part 110. The wavelength conversion part 210 converts the wavelength of light emitted from the second light transmitting resin part 140. That is, the wavelength conversion part 210 converts light emitted from the light emitting diode chip 120 into white light or other colors of light.

The wavelength conversion part 210 may contain phosphors dispersed in a light transmitting resin. For example, the light transmitting resin may be a transparent silicone resin. Further, the phosphors may be yellow phosphors, red phosphors, green phosphors, and the like.

The wavelength conversion part 210 is formed to cover the second light transmitting resin part 140 and the barrier part 110, thereby providing the light emitting device 200 according to the second embodiment.

FIG. 13 is a sectional view of a light emitting device according to a third embodiment of the present disclosure.

Referring to FIG. 13, a light emitting device 100 according to the third embodiment includes a barrier part 310, a light emitting diode chip 120, a first light transmitting resin part 330, and a second light transmitting resin part 140.

The barrier part 310 includes a first inner wall 311 adjoining the side surface of the first light transmitting resin part 330 and a second inner wall 312 adjoining the side surface of the second light transmitting resin part 140.

According to this embodiment, a lower end of the inner wall of the barrier part 310 adjoins a sidewall between the upper surface of the light emitting diode chip 120 and the lower surface thereof. That is, the lower end of the first inner wall 311 of the barrier part 310 is placed between an upper end of the side surface of the light emitting diode chip 120 and a lower end thereof. Here, the lower end of the first inner wall 311 adjoins a side surface of a component placed under the growth substrate of the light emitting diode chip 120. Further, the upper end of the first inner wall 311 is coplanar with the upper surface of the light emitting diode chip 120. Accordingly, the first light transmitting resin part 330 is formed to surround the side surface of the growth substrate of the light emitting diode chip 120 while partially surrounding the side surface of the semiconductor laminate or without surrounding the side surface of the semiconductor laminate. With this structure, a portion of the side surface of the light emitting diode chip 120 closely contacts the barrier part 310.

As shown in the drawings, the second inner wall 312 of the barrier part 310 has an inclined plane in cross-sectional view, like the second inner wall 112 (see FIG. 1) of the barrier part 110 (see FIG. 1) in the light emitting device according to the above embodiment.

The light emitting device 100 according to this embodiment has a larger contact area between the barrier part 310 and the light emitting diode chip 120 than that of the light emitting device according to the above embodiment. With this structure, the light emitting diode chip 120 can be more effectively secured inside the barrier part 310.

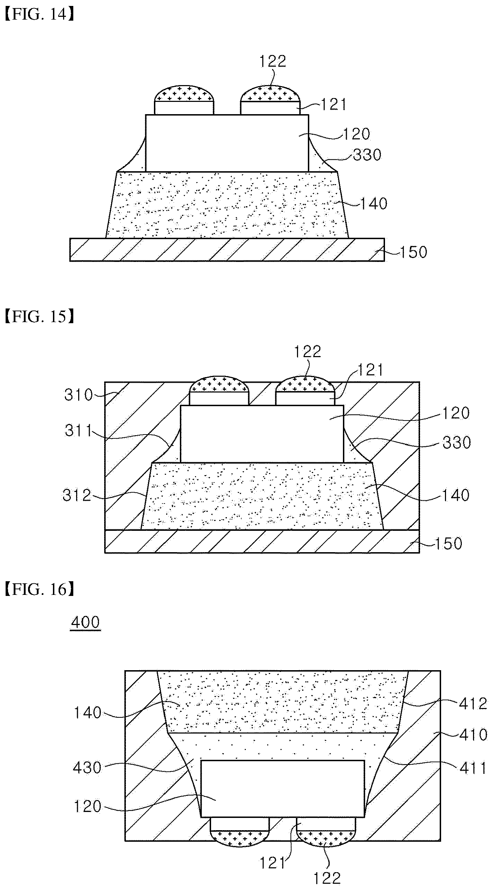

FIG. 14 and FIG. 15 are sectional views illustrating a method of manufacturing the light emitting device according to the third embodiment of the present disclosure.

Referring to FIG. 14, a first light transmitting resin part 330 is formed on a side surface of a light emitting diode chip 120.

A second light transmitting resin part 140 subjected to patterning to have an inclined side surface is formed on a support member 150. The light emitting diode chip 120 is disposed on the second light transmitting resin part 140 such that an upper surface of the light emitting diode chip 120 adjoins an upper surface of the second light transmitting resin part 140. For the method of mounting the light emitting diode chip 120 on the second light transmitting resin part 140, refer to FIG. 3 to FIG. 7.

A resin member having viscosity is deposited on the side surface of the light emitting diode chip 120. Here, the resin member flows down toward an upper portion of the second light transmitting resin part 140 along the side surface of the light emitting diode chip 120. The resin member deposited on the side surface of the light emitting diode chip 120 may also cover a portion of the side surface of the light emitting diode chip 120. That is, in this embodiment, a smaller amount of the resin member is used to form the first light transmitting resin part than the amount of the resin member used to form the first light transmitting resin part 130 (see FIG. 8) in the first or second embodiment. For example, the amount of the resin member is determined to surround the side surface of the growth substrate of the light emitting diode chip 120 while partially surrounding the side surface of the semiconductor laminate grown on the growth substrate or without surrounding the side surface of the semiconductor laminate.

In this way, the first light transmitting resin part 330 is formed by depositing the resin member so as to surround a portion of the side surface of the light emitting diode chip 120.

Referring to FIG. 15, a barrier part 310 is formed on the support member 150 to surround the first light transmitting resin part 330, the second light transmitting resin part 140 and the light emitting diode chip 120.

For details of a method for forming the barrier part 310, refer to FIG. 9 and FIG. 10.

The barrier part 310 is formed to surround the side surface of each of the first light transmitting resin part 330 and the second light transmitting resin part 140. In addition, the barrier part 310 is formed to surround a portion of the side surface of the light emitting diode chip 120 and the lower surface thereof. Here, referring to FIG. 15, at least part of a bonding member 122 formed on the light emitting diode chip 120 is exposed to an upper surface of the barrier part 310.

Thereafter, the support member 150 is removed from the components shown in FIG. 15, thereby providing the light emitting device 300 according to the third embodiment shown in FIG. 13.

Although not shown in the drawings, after removal of the support member 150, a wavelength conversion part (not shown) may be further formed to cover the barrier part 310 and the second light transmitting resin part 140 of the light emitting device 300 (see FIG. 13).

FIG. 16 is a sectional view of a light emitting device according to a fourth embodiment of the present disclosure.

Referring to FIG. 16, a light emitting device 400 according to the fourth embodiment includes a barrier part 410, a light emitting diode chip 120, a first light transmitting resin part 430, and a second light transmitting resin part 140.

The barrier part 410 includes a first inner wall 411 adjoining a side surface of a first light transmitting resin part 430 and a second inner wall 412 adjoining a side surface of the second light transmitting resin part 140.

The first inner wall 411 of the barrier part 410 has a convexly curved plane in cross-section view, as shown in the drawings.

As shown in the drawings, the second inner wall 412 of the barrier part 410 has an inclined plane in cross-section view, like the second inner wall 112 (see FIG. 1) of the barrier part 110 (see FIG. 1) according to the above embodiment.

A lower end of a sidewall of the light emitting diode chip 120 adjoins a lower end of a sidewall of the barrier part 410. That is, the lower end of the first inner wall 411 of the barrier part 410 adjoins the lower end of the sidewall of the light emitting diode chip 120.

The first light transmitting resin part 430 and the second light transmitting resin part 140 may be formed of a light transmitting resin such as a transparent silicone resin. Alternatively, at least one of the first light transmitting resin part 430 and the second light transmitting resin part 140 may contain phosphors dispersed in the light transmitting resin.

According to this embodiment, the first light transmitting resin part 430 is formed to cover a side surface and an upper surface of the light emitting diode chip 120.

The second light transmitting resin part 140 is formed to cover the upper surface of the first light transmitting resin part 430.

An entire lower surface of the second light transmitting resin part 140 closely contacts the first light transmitting resin part 430 including the same material as the second light transmitting resin part 140. As a result, high adhesion is secured between the first light transmitting resin part 430 and the second light transmitting resin part 140, thereby improving durability of the light emitting device 400.

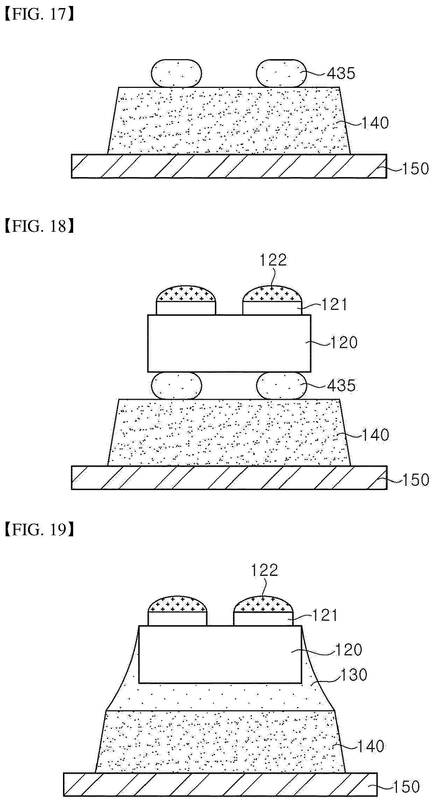

FIG. 17 to FIG. 20 are sectional views illustrating a method of manufacturing the light emitting device according to the fourth embodiment of the present disclosure.

Referring to FIG. 17, a resin member 435 is disposed on the second light transmitting resin part 140.

The resin member 435 is formed of a light transmitting resin. Alternatively, the resin member 435 may contain phosphors dispersed in the light transmitting resin. For example, the light transmitting resin may be a transparent silicone resin.

The resin member 435 may have suitable viscosity to be deformed depending upon the magnitude of force applied thereto while preventing the resin member 435 from flowing along the surface of the second light transmitting resin part 140. Accordingly, the resin member 435 may be kept in a deposited state on the upper surface of the second light transmitting resin part 140.

The second light transmitting resin part 140 is formed on the support member 150. Further, the second light transmitting resin part 140 is formed to have a width gradually narrowing with increasing distance from an upper surface of the support member 150. For a method of forming the second light transmitting resin part 140, refer to FIG. 3 to FIG. 6.

Referring to FIG. 18, a light emitting diode chip 120 is mounted on the resin member 435.

With an upper surface of the light emitting diode chip 120 facing the upper surface of the second light transmitting resin part 140, the light emitting diode chip 120 is mounted on the resin member 435.

Referring to FIG. 19, a first light transmitting resin part 430 is formed to surround the upper and side surfaces of the light emitting diode chip 120.

The resin member 435 (see FIG. 18) is compressed by the light emitting diode chip 120. Then, a portion of the resin member 435 (see FIG. 18) flows along the surface of the light emitting diode chip 120 to surround the entirety of the side surface of the light emitting diode chip 120 by the applied force. As such, some of the resin member 435 (see FIG. 18) covers the upper surface of the light emitting diode chip 120 and the other resin member 435 covers the entire side surface of the light emitting diode chip 120 to form the first light transmitting resin part 430.

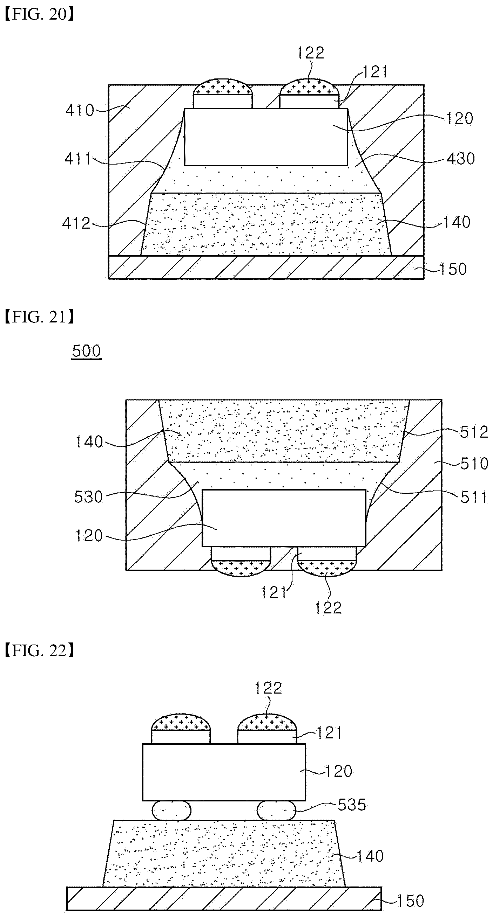

Referring to FIG. 20, a barrier part 410 is formed to surround the first light transmitting resin part 430, the second light transmitting resin part 140 and the light emitting diode chip 120 on the support member 150. For a method of forming the barrier part 410, refer to FIG. 9 and FIG. 10.

The barrier part 410 includes a cavity in which the first light transmitting resin part 430, the second light transmitting resin part 140 and the light emitting diode chip 120 are disposed. An inner wall of the barrier part 410 defining the cavity is formed to surround side surfaces of the first light transmitting resin part 430 and the second light transmitting resin part 140. Accordingly, the first inner wall 411 surrounding the side surface of the first light transmitting resin part 430 has a convexly curved plane in cross-section view and the second inner wall 412 surrounding the side surface of the second light transmitting resin part 140 has an inclined plane in cross-sectional view. An upper end of the first inner wall 411 is placed higher than the upper surface of the light emitting diode chip 120.

Further, the barrier part 410 is formed to surround a portion of the side surface of the light emitting diode chip 120 and a lower surface thereof.

Thereafter, the support member 150 is removed from the components shown in FIG. 20, thereby providing the light emitting device 400 according to the fourth embodiment shown in FIG. 16.

Although not shown in the drawings, after removal of the support member 150, a wavelength conversion part (not shown) may be further formed to cover the barrier part 410 and the second light transmitting resin part 140 of the light emitting device 400 (see FIG. 16).

FIG. 21 is a sectional view of a light emitting device according to a fifth embodiment of the present disclosure.

Referring to FIG. 21, a light emitting device 500 according to the fifth embodiment includes a barrier part 510, a light emitting diode chip 120, a first light transmitting resin part 530, and a second light transmitting resin part 140.

An inner wall of the barrier part 510 may be divided into a first inner wall 511 adjoining a side surface of the first light transmitting resin part 530 and a second inner wall 512 adjoining a side surface of the second light transmitting resin part 140.

The first light transmitting resin part 530 is formed to cover a portion of a side surface of the light emitting diode chip 120 and an upper surface thereof. Further, the second light transmitting resin part 140 is formed to cover an upper surface of the first light transmitting resin part 530.

According to this embodiment, a lower end of the first light transmitting resin part 530 adjoins the side surface of the light emitting diode chip 120. More specifically, the first light transmitting resin part 530 surrounds a side surface of a growth substrate of the light emitting diode chip 120 while partially surrounding the side surface of the semiconductor laminate or without surrounding the side surface of the semiconductor laminate. Accordingly, a portion of the side surface of the light emitting diode chip 120 closely contacts the barrier part 510.

According to this embodiment, a bonding area between the barrier part 510 and the light emitting diode chip 120 is increased above the bonding area therebetween according to the fourth embodiment, whereby the light emitting diode chip 120 can be more effectively secured inside the barrier part 510. Further, according to this embodiment, the entire lower surface of the second light transmitting resin part 140 closely contacts the first light transmitting resin part 530, thereby improving adhesion between the first light transmitting resin part 530 and the second light transmitting resin part 140. As a result, the light emitting device 500 according to this embodiment has improved durability through improvement in securing force and adhesive strength between the components thereof.

FIG. 22 to FIG. 24 are sectional views illustrating a method of manufacturing the light emitting device according to the fifth embodiment.

Referring to FIG. 22, a light emitting diode chip 120 is mounted on a resin member 535 disposed on a second light transmitting resin part 140. The light emitting diode chip 120 is mounted on the resin member 535 such that the upper surface of the light emitting diode chip 120 faces the upper surface of the second light transmitting resin part 140.

For a method of forming the second light transmitting resin part 140, refer to FIG. 3 to FIG. 6.

In this embodiment, the resin member 535 is deposited in a smaller amount than the resin member 435 (see FIG. 17) on the second light transmitting resin part 140 in the fourth embodiment. Although the amount of the resin member 435 (see FIG. 17) is determined to surround the entire side surface of the light emitting diode chip 120, the amount of the resin member 535 according to this embodiment is smaller than the amount of the resin member 435 (see FIG. 17) according to the fourth embodiment.

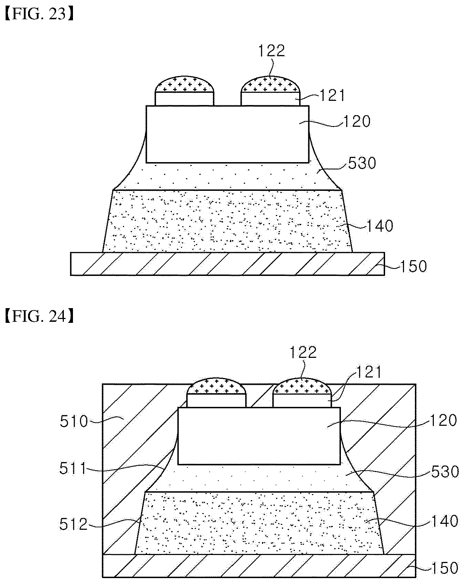

Referring to FIG. 23, a first light transmitting resin part 530 is formed to surround the upper surface of the light emitting diode chip 120 and a portion of a side surface thereof.

The resin member 535 (see FIG. 22) is compressed by the light emitting diode chip 120 placed thereon. Some of the resin member 535 (see FIG. 22) flows along the surface of the light emitting diode chip 120 to surround a portion of the side surface of the light emitting diode chip 120 by the applied force. Here, the degree of surrounding the side surface of the light emitting diode chip 120 is changed depending upon the amount of the resin member 535 (see FIG. 22).

According to this embodiment, as shown in FIG. 23, some of the resin member 535 (see FIG. 22) covers the upper surface of the light emitting diode chip 120 and the other resin member 535 covers a portion of the side surface of the light emitting diode chip 120 to form the first light transmitting resin part 530.

Referring to FIG. 24, a barrier part 510 is formed to surround the first light transmitting resin part 530, the second light transmitting resin part 140 and the light emitting diode chip 120 on a support member 150. For details of a method of forming the barrier part 510, refer to FIG. 9 and FIG. 10.

The barrier part 510 includes a cavity in which the light emitting diode chip 120, the first light transmitting resin part 530 and the second light transmitting resin part 140 are disposed. A first inner wall 511 surrounding the side surface of the first light transmitting resin part 530 has a convexly curved plane and the second inner wall 512 surrounding the side surface of the second light transmitting resin part 140 has an inclined plane. An upper end of the first inner wall 511 is placed higher than the upper surface of the light emitting diode chip 120. Further, a lower end of the first inner wall 511 adjoins the side surface of the light emitting diode chip 120. Accordingly, a portion of the side surface of the light emitting diode chip 120 closely contacts the barrier part 510.

Although not shown in the drawings, after removal of the support member 150, a wavelength conversion part (not shown) may be further formed to cover the barrier part 510 and the second light transmitting resin part 140 of the light emitting device 500.

Although some embodiments have been described herein with reference to the accompanying drawings, it should be understood that these embodiments are provided for illustration only and are not to be construed in any way as limiting the present disclosure. Therefore, it should be understood that the scope of the present disclosure should be defined by the appended claims and equivalents thereto.

## Claims

1. A light emitting device comprising:
a light emitting diode chip emitting light;
a first light transmitting resin part surrounding at least part of a side surface of the light emitting diode chip;
a second light transmitting resin part covering an upper side of the first light transmitting resin part and an upper side of the light emitting diode chip; and
a barrier part surrounding side surfaces of the light emitting diode chip, the first light transmitting resin part and the second light transmitting resin part and a lower surface of the light emitting diode chip,
wherein each of the first light transmitting resin part and the second light transmitting resin part has a width gradually increasing from a lower portion thereof to an upper portion thereof, and
an inner wall of the barrier part adjoins the side surface of the light emitting diode chip or a lower end of the side surface thereof,
the inner wall of the barrier part being divided into a first inner wall having a convexly curved plane and a second inner wall having an inclined plane in cross-sectional view.

2. The light emitting device according to claim 1, wherein the first inner wall of the barrier part surrounds the side surface of the first light transmitting resin part and the second inner wall of the barrier part surrounds the side surface of the second light transmitting resin part.

3. The light emitting device according to claim 2, wherein the side surface of the first light transmitting resin part closely contacts the first inner wall of the barrier part and comprises a concavely curved plane.

4. The light emitting device according to claim 2, wherein the side surface of the second light transmitting resin part closely contacts the second inner wall of the barrier part and comprises an inclined plane.

5. The light emitting device according to claim 2, wherein a lower end of the first inner wall of the barrier part adjoins the lower end of the side surface of the light emitting diode chip.

6. The light emitting device according to claim 2, wherein a lower end of the first inner wall of the barrier part is placed at a height spaced apart from the lower end of the light emitting diode chip while adjoining the side surface of the light emitting diode chip.

7. The light emitting device according to claim 2, wherein an upper end of the first inner wall of the barrier part is coplanar with an upper surface of the light emitting diode chip.

8. The light emitting device according to claim 7, wherein a lower surface of the second light transmitting resin part adjoins an upper surface of the first light transmitting resin part and the upper surface of the light emitting diode chip.

9. The light emitting device according to claim 5, wherein an upper end of the first inner wall of the barrier part is placed higher than an upper surface of the light emitting diode chip.

10. The light emitting device according to claim 9, wherein the first light transmitting resin part surrounds at least part of the side surface of the light emitting diode chip and the upper surface thereof, and an entire lower surface of the second light transmitting resin part adjoins an upper surface of the first light transmitting resin part.

11. The light emitting device according to claim 1, wherein the first light transmitting resin part and the second light transmitting resin part are formed of a transparent resin allowing transmission of light therethrough.

12. The light emitting device according to claim 11, wherein the transparent resin is a transparent silicone resin.

13. The light emitting device according to claim 11, wherein at least one of the first light transmitting resin part and the second light transmitting resin part further comprises a phosphor.

14. The light emitting device according to claim 1, further comprising:
a wavelength conversion part covering an upper surface of the second light transmitting resin part and an upper surface of the barrier part.

15. The light emitting device according to claim 14, wherein the wavelength conversion part is phosphor-in-glass (PIG).

16. The light emitting device according to claim 1, wherein the inner wall of the barrier part reflects light emitted from the light emitting diode chip.

17. The light emitting device according to claim 1, wherein the light emitting diode chip comprises a bump pad formed on the lower surface thereof and connected to an electrode formed thereon.

18. The light emitting device according to claim 17, wherein at least part of the bump pad of the light emitting diode chip is embedded in the barrier part.

19. The light emitting device according to claim 17, further comprising:
a bonding member formed on a lower side of the bump pad.

20. The light emitting device according to claim 19, wherein at least part of the bonding member is exposed from a lower surface of the barrier part.
